(19) Europäisches Patentamt
European Patent Office
Office européen des brevets

(11) **EP 3 913 116 A1**

(12) **EUROPEAN PATENT APPLICATION**
published in accordance with Art. 153(4) EPC

(43) Date of publication:
**24.11.2021 Bulletin 2021/47**

(51) Int Cl.:
*C30B 25/02* (2006.01)  *H01L 21/20* (2006.01)
*H01L 21/205* (2006.01)  *H01L 21/338* (2006.01)
*H01L 29/778* (2006.01)  *H01L 29/812* (2006.01)
*C30B 29/38* (2006.01)  *C23C 16/34* (2006.01)

(21) Application number: **20741454.1**

(22) Date of filing: **08.01.2020**

(86) International application number:
**PCT/JP2020/000246**

(87) International publication number:
**WO 2020/149184 (23.07.2020 Gazette 2020/30)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **16.01.2019 JP 2019005056**

(71) Applicant: **Air Water Inc.
Osaka-shi
Osaka 542-0081 (JP)**

(72) Inventors:
• **SUZUKI, Hiroki
Matsumoto-shi Nagano 390-1701 (JP)**
• **OUCHI, Sumito
Matsumoto-shi Nagano 390-1701 (JP)**
• **NARUKAWA, Mitsuhisa
Matsumoto-shi Nagano 390-1701 (JP)**
• **KAWAMURA, Keisuke
Matsumoto-shi Nagano 390-1701 (JP)**

(74) Representative: **Hering, Hartmut
Patentanwälte
Berendt, Leyh & Hering
Innere Wiener Strasse 20
81667 München (DE)**

(54) **COMPOUND SEMICONDUCTOR SUBSTRATE**

(57)     A compound semiconductor substrate that can improve in-plane uniformity of current-voltage characteristics in the vertical direction is provided.

A compound semiconductor substrate includes a center and an edge which is 71.2 millimeters away from the center when viewed in a plane. When a film thickness of the GaN layer at the center of the compound semiconductor substrate is W1 and a film thickness of the GaN layer at the edge is W2, film thickness error $\Delta W$ represented by $\Delta W (\%) = | Wt-W2 | * 100 / W1$ is greater than 0 and 8% or less. The average carbon concentration in the depth direction at a center of the GaN layer is $3 * 10^{18}$ pieces / cm$^3$ or more and $5 * 10^{20}$ pieces / cm$^3$ or less. When a carbon concentration at a center position of the depth direction at the center of the GaN layer is concentration C1 and a carbon concentration at a center position of the depth direction at the edge of the GaN layer is concentration C2, concentration error $\Delta C$ represented by $\Delta C (\%) = | C1-C2 | * 100 / C1$ is 0 or more and 50% or less.

FIG. 4

# Description

## TECHNOLOGICAL FIELD

The present invention relates to a compound semiconductor substrate. More specifically, the present invention relates to a compound semiconductor substrate with a GaN (gallium nitride) layer.

## DESCRIPTION OF THE RELATED ART

GaN is known as wide band gap semiconductor material, which has a larger band gap and a higher insulation breakdown field strength than Si (silicon). Since GaN has a higher dielectric breakdown resistance than other wide band gap semiconductor materials, it is expected to be applied to next-generation low-loss power devices.

When a Si substrate is used for a start substrate (foundation substrate) of a semiconductor device using GaN, due to the large difference in lattice constant values and thermal expansion coefficients between GaN and Si, phenomenon in which warpage occurs in a substrate and cracks occur in a GaN layer are likely to be caused. For this reason, it has been proposed to mitigate the lattice constant value differences and thermal expansion coefficient differences between GaN and Si by forming a buffer layer on the Si substrate.

Conventional techniques for forming a GaN layer are disclosed, for example, in Patent Documents 1 and 2 below. In the following Patent Document 1 etc., a semiconductor substrate including a Si substrate, a 3C-SiC layer (silicon carbide) formed on the Si substrate, and AlN (aluminum nitride) layers and GaN layers formed alternately is disclosed.

Patent Document 2 below discloses a semiconductor substrate comprising a substrate consisting of Si, a buffer layer in which AlGaN (aluminum nitride gallium) layers and GaN layers are repeatedly stacked, formed on the substrate, a high resistance layer consisting of a GaN layer containing Fe (iron) provided on the buffer layer, a channel layer made of GaN provided on the high resistance layer, and a barrier layer made of AlGaN installed on the channel layer.

Prior Art Document

Document(s) related to patents

[Patent Document1] Japanese published unexamined application No. 2013-179121
[Patent Document2] Japanese Translation of PCT International Application Publication No. 2015-201574

## SUMMARY OF THE INVENTION

[Problems to be resolved by this invention]

According to a compound semiconductor substrate with a GaN layer, in order to improve the withstand voltage in the vertical direction (the direction orthogonal to a principal surface of the GaN layer), there are also cases in which the insulation of the GaN layer is increased by adding C (carbon) to the GaN layer. However, when C is conventionally added to the GaN layer, the carbon concentration is different depending on the position in the principal surface of the GaN layer, and the in-plane uniformity of the carbon concentration was low. As a result, the vertical current-voltage characteristics of the compound semiconductor substrate differs depending on the position in the principal surface of the GaN layer, and there was a problem that the in-plane uniformity of current-voltage characteristics in the vertical direction was low.

The present invention is to solve the above problems, and the object is to provide a compound semiconductor substrate that can improve in-plane uniformity of current-voltage characteristics in the vertical direction.

[Means to solve problems]

According to one aspect of the invention, a compound semiconductor substrate with a center and an edge which is 71.2 millimeters away from the center when viewed in a plane comprising: a Si substrate, a buffer layer containing AlN formed on a top surface side of the Si substrate, a nitride semiconductor layer containing Al formed on a top surface side of the buffer layer, and a GaN layer formed on a top surface side of the nitride semiconductor layer, wherein when a film thickness of the GaN layer at the center is film thickness W1 and a film thickness of the GaN layer at the edge is film thickness W2, film thickness error $\Delta W$ represented by $\Delta W$ (%) = | W1-W2 | $*$ 100 / W1 is greater than 0 and 8% or less, an average carbon concentration of a depth direction at the center of the GaN layer is $3 * 10^{18}$ pieces / $cm^3$ or more and $5 * 10^{20}$ pieces / $cm^3$ or less, and when a carbon concentration at a center position of a depth direction at the center of the GaN layer is concentration C1, and a carbon concentration at a center position of the depth direction in the edge of the GaN layer is concentration C2, concentration error $\Delta C$ represented by $\Delta C$ (%) = | C1-C2 | $*$ 100 / C1 is 0 or more and 50% or less.

Preferably, the compound semiconductor substrate further comprises a SiC layer formed on a top surface of the Si substrate.

Preferably, the compound semiconductor substrate further comprises a composite layer formed on the top surface side of the nitride semiconductor layer, wherein the composite layer includes the GaN layer, and an AlN layer formed on a top surface of the GaN layer.

Preferably, according to the compound semiconductor substrate, a vertical intrinsic breakdown voltage value of the compound semiconductor substrate is 1200V or more and 1600V or less.

Preferably, according to the compound semiconductor substrate, a defect density of the center of the GaN layer causing insulation breakdown at a voltage value 80% or less of the intrinsic breakdown voltage value is greater than 0 and less than or equal to 100 pieces / cm$^2$.

Preferably, according to the compound semiconductor substrate, a defect density of the edge of the GaN layer causing insulation breakdown at a voltage value 80% or less of the intrinsic breakdown voltage value is greater than 0 and less than or equal to 7 pieces / cm$^2$.

Preferably, according to the compound semiconductor substrate, an area from the center to the edge is crack-free.

Preferably, according to the compound semiconductor substrate, meltback-free is satisfied on an entire surface of the substrate.

EFFECT OF THE INVENTION

According to the present invention, a compound semiconductor substrate that can improve in-plane uniformity of current-voltage characteristics in the vertical direction can be provided.

BRIEF DESCRIPTION OF THE DRAWINGS

FIG. 1 is a cross-sectional view showing the configuration of compound semiconductor substrate CS1 in the first embodiment of the present invention.
FIG. 2 is a diagram showing the distribution of the Al (aluminum) composition ratio inside Al nitride semiconductor layer 4 in the first embodiment of the present invention.
FIG. 3 is a diagram schematically showing the two-dimensional growth of GaN constituting the GaN layer.
FIG. 4 is a plan view showing the configuration of compound semiconductor substrate CS1 in the first embodiment of the present invention.
FIG. 5 is a cross-sectional view showing the configuration of compound semiconductor substrate CS2 in the second embodiment of the present invention.
FIG. 6 is a diagram showing the distribution of the Al composition ratio inside Al nitride semiconductor layer 4 in the first modification of the present invention.
FIG. 7 is a diagram showing the distribution of the Al composition ratio inside Al nitride semiconductor layer 4 in the second modification of the present invention.
FIG. 8 is a cross-sectional view showing the configuration of Sample 3 (compound semiconductor substrate CS10) in the first Example of the present invention.
FIG. 9 is a cross-sectional view showing a method of measuring the vertical withstand voltage in the first Example of the present invention.
FIG. 10 is a cross-sectional view showing the configuration of compound semiconductor substrate CS3 in the second Example of the present invention.
FIG. 11 is a diagram showing the value of concentration error ΔC calculated in the second Example of the present invention.
FIG. 12 is a diagram showing the value of film thickness error ΔW calculated in the second Example of the present invention.
FIG. 13 is a diagram showing the value of the defect density measured in the second Example of the present invention.

DETAILED DESCRIPTION OF EMBODIMENTS

Hereinafter, embodiments of the present invention will be described with reference to the drawings.

[First embodiment]

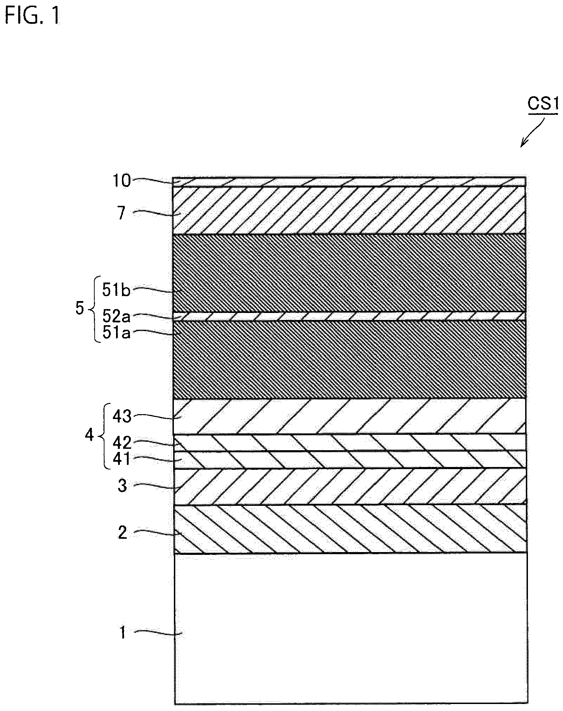

FIG. 1 is a cross-sectional view showing the configuration of compound semiconductor substrate CS1 in the first embodiment of the present invention.

Referring to FIG. 1, the compound semiconductor substrate CS1 according to this embodiment includes a HEMT (High Electron Mobility Transistor). Compound semiconductor substrate CS1 includes Si substrate 1, SiC layer 2, AlN buffer layer 3 (an example of a buffer layer consisting of AlN), Al nitride semiconductor layer 4 (an example of a nitride semiconductor layer containing Al), composite layer 5, GaN layer 7, and Al nitride semiconductor layer 10.

Si substrate 1 consists of, for example, p+ type Si. The (111) plane is exposed on a surface of Si substrate 1. Note that Si substrate 1 may have n-type conductivity or may be semi-insulating. The (100) plane or the (110) plane may be exposed on the surface of Si substrate 1. Si substrate 1 has a diameter of, for example, 6 inches and a thickness of 1000 micrometers.

SiC layer 2 is in contact with Si substrate 1 and is formed on Si substrate 1. SiC layer 2 consists of 3C-SiC, 4H-SiC, 6H-SiC, or the like. In particular, if SiC layer 2 is epitaxially grown on Si substrate 1, then typically, SiC layer 2 consists of 3C-SiC.

SiC layer 2 may be formed by homo-epitaxial growth of SiC on a foundation layer consisting of SiC obtained by carbonizing the surface of Si substrate 1, using an MBE (Molecular Beam Epitaxy) method, a CVD (Chemical Vapor Deposition) method, a LPE (Liquid Phase Epitaxy) method, etc. SiC layer 2 may be formed only by carbonizing the surface of Si substrate 1. Further, SiC layer 2 may be formed by hetero epitaxial growth on a surface of Si substrate 1 (or interposing a buffer layer therebetween). SiC layer 2 is doped with, for example, N (nitrogen) and has n-type conductivity. SiC layer 2 has a thickness of, for example, 0.1 micrometers or more and 3.5 micrometers or less. Note that SiC layer 2 may have p-type conductivity or may be semi-insulating.

AlN buffer layer 3 is a layer containing AlN and is formed on the top surface side of Si substrate 1. Here, AlN buffer layer 3 is in contact with SiC layer 2 and formed on SiC layer 2. AlN buffer layer 3 acts as a buffer layer that reduces the difference of lattice constant values between SiC layer 2 and Al nitride semiconductor layer 4. AlN buffer layer 3 is formed using, for example, a MOCVD (Metal Organic Chemical Vapor Deposition) method. The growth temperature of AlN buffer layer 3 is, for example, 1000 degrees Celsius or more and 1300 degrees Celsius or less. At this time, as Al source gas, for example, TMA (Tri Methyl Aluminum), TEA (Tri Ethyl Aluminum) or the like is used, As N source gas, for example, $NH_3$ (ammonia) is used. AlN buffer layer 3 has a thickness of, for example, 100 nanometers or more and 1000 nanometers or less.

Al nitride semiconductor layer 4 is formed on the top surface side of AlN buffer layer 3. Here, Al nitride semiconductor layer 4 is in contact with AlN buffer layer 3 and is formed on AlN buffer layer 3. Al nitride semiconductor layer 4 consists of nitride semiconductor containing Al, for example, it is made of a material represented by $Al_xGa_{1-x}N$ ($0 < x \leq 1$). Further, Al nitride semiconductor layer 4 may be made of a material represented by $Al_xIn_yGa_{1-x-y}N$ ($0 < x \leq 1$, $0 \leq y < 1$). Al nitride semiconductor layer 4 acts as a buffer layer that reduces the lattice constant value difference between AlN buffer layer 3 and C-GaN layer 51a in composite layer 5. Al nitride semiconductor layer 4 has a thickness of, for example, 500 nanometers or more and 2 micrometers or less, preferably 900 nanometers or more and 2 micrometers or less. Al nitride semiconductor layer 4 is formed using, for example, an MOCVD method.

Composite layer 5 is formed on the top surface side of Al nitride semiconductor layer 4. Here, composite layer 5 is in contact with Al nitride semiconductor layer 4 and is formed on Al nitride semiconductor layer 4. Composite layer 5 includes multiple C-GaN layers stacked in a vertical direction (a direction same as the lamination direction of Si substrate 1, SiC layer 2, AlN buffer layer 3, and Al nitride semiconductor layer 4, which is the vertical direction in FIG. 1) and AlN layer(s) formed between two of the multiple C-GaN layers. In other words, composite layer 5 has a stacked configuration in which C-GaN layer(s) and AlN layer(s) alternate one or more times, and the top layer and the bottom layer of composite layer 5 are both C-GaN layers. The C-GaN layer is a GaN layer (a C-doped GaN layer) containing C (carbon). C plays a role in enhancing the insulation of the GaN layer.

The number of C-GaN layers that composes composite layer 5 may be 2 or more, and the number of AlN layers constituting composite layer 5 is also arbitrary. Composite layer 5 of this embodiment includes 2 layers of C-GaN layers 51a and 51b as C-GaN layers (an example of GaN layers) and 1 layer of AlN layer 52a (an example of an AlN layer). C-GaN layer 51a is the lowest layer of the layers that make up composite layer 5, and in contact with Al nitride semiconductor layer 4. C-GaN layer 51b is the highest layer among the layers that make up composite layer 5, and in contact with GaN layer 7. AlN layer 52a is formed between C-GaN layer 51a and C-GaN layer 51b.

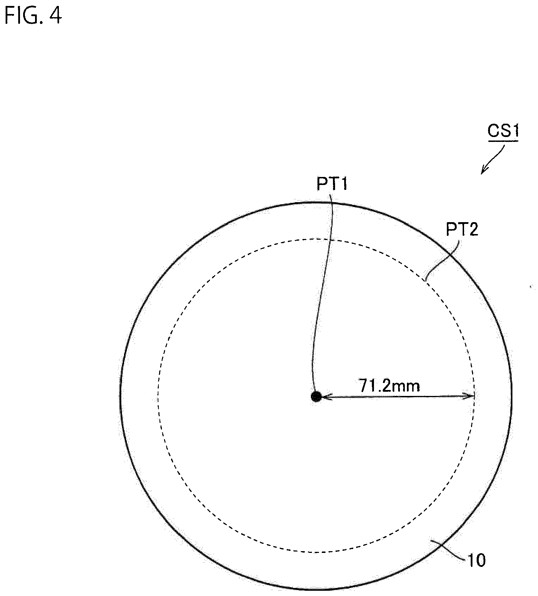

In each of the plurality of C-GaN layers (C-GaN layers 51a and 51b in this embodiment) constituting composite layer 5, the average carbon concentration in the depth direction at center PT1 (FIG. 4) is $3 * 10^{18}$ pieces / $cm^3$ or more and $5 * 10^{20}$ pieces / $cm^3$ or less, preferably $3 * 10^{18}$ pieces / $cm^3$ or more and $2 * 10^{19}$ pieces / $cm^3$. The plurality of GaN layers constituting composite layer 5 may have the same average carbon concentration or may have different average carbon concentration from each other.

Each of the plurality of C-GaN layers constituting composite layer 5 has a thickness of, for example, 550 nanometers or more and 3000 nanometers or less, preferably 800 nanometers or more and 2500 nanometers or less. The plurality of C-GaN layers constituting composite layer 5 may have the same thickness or may have different thicknesses from each other,

The AlN layer (AlN layer 52a in this embodiment) constituting composite layer 5 has a thickness of, for example, 3 nanometers or more and 50 nanometers or less, preferably 20 nanometers or less. When there are a plurality of AlN layers constituting composite layer 5, the AlN layers constituting composite layer 5 may have the same thickness or different thicknesses from each other.

C-GaN layers 51a and 51b constituting composite layer 5 are formed using an MOCVD method, At this time, as Ga source gas, for example, TMG (Tri Methyl Gallium) or TEG (Tri Ethyl Gallium) is used. As N source gas, for example, $NH_3$ is used. The AlN layer constituting composite layer 5 is formed in the same manner as AlN buffer layer 3.

Typically, when forming a C-GaN layer, the growth temperature of the GaN layer is set lower than the growth temperature of a GaN layer in which C is not imported (in particular, a temperature about 300 degrees Celsius lower than the growth temperature of a GaN layer which is not doped with C is set). As a result, C contained in the Ga source gas is taken into the GaN layer, and the GaN layer becomes a C-GaN layer. On the other hand, when the growth temperature of the GaN layer becomes low, the quality of the C-GaN layer deteriorates, and the C concentration in-plane uniformity of the C-GaN layer decreases.

Therefore, the inventors of the present application found a way to introduce hydrocarbon as C source gas (C precursor) together with Ga source gas and N source gas into the reaction chamber, when forming GaN layers (Here, C-GaN layers 51a and 51b respectively) in a configuration with a Si substrate, a buffer layer containing AlN formed on the top surface side of the Si substrate, a nitride semiconductor layer containing Al formed on the top surface side of the buffer layer, and a GaN layer formed on the top surface side of the nitride semiconductor layer. Since this method facilitates the uptake of C into GaN layer, C-GaN layers can be formed while setting the GaN growth temperature to a high temperature (In particular, a temperature about 200 degrees Celsius lower than a growth temperature of a GaN layer which is not doped with C is set). As a result, the quality of the C-GaN layers is improved, and the C concentration in-plane uniformity of the C-GaN layers is improved.

Specifically, as C source gas, hydrocarbon such as methane, ethane, propane, butane, pentane, hexane, heptane, octane, ethylene, propylene, butene, pentene, hexene, heptene, octene, acetylene, propyne, butin, pentin, hexin, heptin, or octyne is used. Especially, hydrocarbon including double or triple bonds is preferred because it has high reactivity. As C source gas, only one type of hydrocarbon may be used, or two or more types of hydrocarbons may be used.

Another layer such as an undoped GaN layer may intervene between Al nitride semiconductor layer 4 and composite layer 5.

GaN layer 7 is in contact with composite layer 5 and is formed on composite layer 5. GaN layer 7 is undoped and semi-insulating. GaN layer 7 becomes an electronic traveling layer of the HEMT. GaN layer 7 has a thickness of, for example, 100 nanometers or more and 1000 nanometers or less. GaN layer 7 is formed using, for example, an MOCVD method. At this time, as Ga source gas, for example, TMG or TEG is used. As N source gas, for example, $NH_3$ is used.

Al nitride semiconductor layer 10 is in contact with GaN layer 7 and is formed on GaN layer 7. Al nitride semiconductor layer 10 consists of nitride semiconductor containing Al, for example, it is made of a material represented by $Al_xGa_{1-x}N$ ($0 < x \leqq 1$). Further, Al nitride semiconductor layer 10 may be made of a material represented by $Al_xIn_yGa_{1-x-y}N$ ($0 < x \leqq 1$, $0 \leqq y < 1$). Al nitride semiconductor layer 10 becomes a barrier layer of the HEMT. Al nitride semiconductor layer 10 has a thickness of, for example, 10 nanometers or more and 50 nanometers or less. Al nitride semiconductor layer 10 is formed in the same manner as Al nitride semiconductor layer 4.

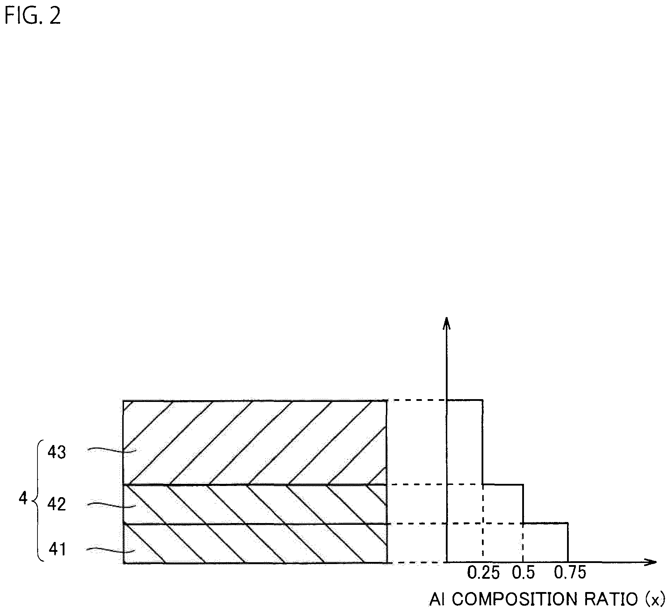

FIG. 2 is a diagram showing the distribution of the Al composition ratio inside Al nitride semiconductor layer 4 according to the first embodiment of the present invention.

Referring to FIG. 2, the composition ratio of Al inside Al nitride semiconductor layer 4 decreases from the bottom to the top. Al nitride semiconductor layer 4 includes $Al_{0.75}Ga_{0.25}N$ layer 41 (an AlGaN layer with a composition ratio of Al is 0.75), $Al_{0.5}Ga_{0.5}N$ layer 42 (an AlGaN layer with a composition ratio of Al is 0.5), and $Al_{0.25}Ga_{0.75}N$ layer 43 (an AlGaN layer with a composition ratio of Al is 0.25). $Al_{0.75}Ga_{0.25}N$ layer 41 is formed on AlN buffer layer 3 and in contact with AlN buffer layer 3. $Al_{0.5}Ga_{0.5}N$ layer 42 is formed on $Al_{0.75}Ga_{0.25}N$ layer 41 and in contact with $Al_{0.75}Ga_{0.25}N$ layer 41. $Al_{0.25}Ga_{0.75}N$ layer 43 is formed on $Al_{0.5}Ga_{0.5}N$ layer 42 and in contact with $Al_{0.5}Ga_{0.5}N$ layer 42. The above Al composition ratios are examples, and if the Al composition ratio decreases from the lower part to the upper part, other compositions can be adopted.

According to this embodiment, by forming AlN layer 52a between C-GaN layer 51a and C-GaN layer 51b in composite layer 5, the occurrence of warpage in Si substrate 1 can be suppressed, and the occurrence of cracks into C-GaN layer 51b and GaN layer 7 can be suppressed. This will be described below.

AlN constituting AlN layer 52a is in an unconformity state (under the situation in which sliding has occurred) to crystals of GaN constituting C-GaN layer 51a, and the AlN constituting AlN layer 52a is epitaxially grown on the top of the C-GaN layer 51a. On the other hand, the GaN that composes C-GaN layer 51b and GaN layer 7 is affected by the crystals of AlN that composes AlN layer 52a which is the foundation. That is, the GaN that makes up C-GaN layer 51b and GaN layer 7 is epitaxially grown on the top of the AlN layer 52a so that they take over the crystal structure of AlN that makes up AlN layer 52a. Since the GaN lattice constant value is larger than the AlN lattice constant value, the lattice constant value in the horizontal direction in FIG. 1 of the GaN constituting GaN layer 51b is smaller than the lattice constant value of general GaN (without compressive strain). In other words, C-GaN layer 51b and GaN layer 7 contain compressive strain inside.

When the temperature drops after the formation of C-GaN layer 51b and GaN layer 7, due to the difference in thermal expansion coefficient between GaN and Si, C-GaN layer 51b and GaN layer 7 receive stress from AlN layer 52a. This stress causes the occurrence of warpage of Si substrate 1 and causes the occurrence of cracks into C-GaN layer 51b and GaN layer 7. However, this stress is mitigated by the compressive strain introduced inside the C-GaN layer 51b and GaN layer 7 during the formation of the C-GaN layer 51b and GaN layer 7. As a result, the occurrence of warpage in Si substrate 1 can be suppressed, and the occurrence of cracks into C-GaN layer 51b and GaN layer 7 can be suppressed.

Compound semiconductor substrate CS1 includes C-GaN layers 51a and 51b, AlN layer 52a, and Al nitride semiconductor layer 4 with insulation breakdown voltage higher than GaN insulation breakdown voltage. As a result, the vertical withstand voltage of the compound semiconductor substrate can be improved.

Further, according to this embodiment, since compound semiconductor substrate CS1 contains Al nitride semiconductor layer 4 between AlN buffer layer 3 and C-GaN layer 51a in composite layer 5, the difference between the lattice constant value of Si and the lattice constant value of GaN can be reduced. This is because the lattice constant value of Al nitride semiconductor layer 4 is between the lattice constant value of Si and the lattice constant value of GaN. As a result, crystal quality of C-GaN layers 51a and 51b can be improved. In addition, the occurrence of warpage of Si substrate I can be suppressed, and the occurrence of cracks into C-GaN layers 51a and 51b can be suppressed.

According to this embodiment, as mentioned above, since the occurrence of warpage of Si substrate 1 and the occurrence of cracks into C-GaN layer 51b and GaN layer 7 are suppressed, GaN layer 7 can be thickened.

Further, compound semiconductor substrate CS1 contains C-GaN layers 51a and 51b, and SiC layer 2 as a foundation layer for GaN layer 7. Since the lattice constant value of SiC is closer to the lattice constant value of GaN than the lattice constant value of Si, the formation of C-GaN layer 51a and 51b, and GaN layer 7 on SiC layer 2 can improve the crystal quality of C-GaN layer 51a and 51b, and GaN layer 7.

According to this embodiment as described above, by separating the functions of Al nitride semiconductor layer 4, composite layer 5, and SiC layer 2, each of the effect of suppressing the occurrence of warpage of Si substrate 1, the effect of suppressing the occurrence of cracks into C-GaN layer 51b and GaN layer 7, the effect of improving withstand voltage of compound semiconductor substrate CS1, and the crystal quality improving effect for C-GaN layers 51a and 51b, and GaN layer 7 can be increased. In particular, according to the present embodiment, by making SiC layer 2 to a foundation layer, the contribution of improving the crystal quality of GaN layer 7 is large.

According to this embodiment, by installing SiC layer 2 and improving the crystal quality of C-GaN layers 51a and 51b, and GaN layer 7, the thickness of the AlN layer in composite layer 5 can be reduced, and the generation of warpage and the generation of cracks can be suppressed more efficiently. Further, by installing SiC layer 2 and improving crystal quality of C-GaN layer 51a, since C-GaN layers 51a and 51b, and GaN layer 7 can be thickened, the withstand voltage can be further improved. The performance of the HEMT can also be improved.

Further, by introducing hydrocarbon as C source gas when forming each of C-GaN layers 51a and 51b, the following effects can be obtained.

By introducing hydrocarbon as C source gas when forming each of C-GaN layers 51a and 51b, C-GaN layers 51a and 51b can be formed while setting the GaN growth temperature to a high temperature. The high GaN growth temperature improves the quality of C-GaN layers 51a and 51b.

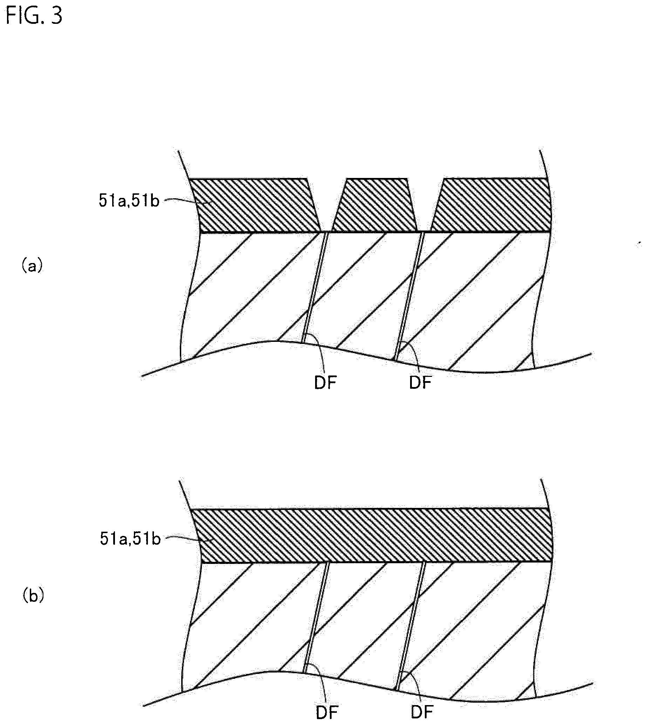

FIG. 3 is a diagram schematically showing the two-dimensional growth of GaN constituting the GaN layer, FIG. 3(a) shows the growth of GaN, when the growth temperature is low, and FIG. 3(b) shows the growth of GaN, when the growth temperature is high.

With reference to FIG. 3(a), if the GaN growth temperature is low, since two-dimensional growth of the GaN layer (the horizontal direction in FIG. 3) is slow, defects DF such as pits that were present in the layer under each of GaN layers 51a or 51b are not covered by GaN layers 51a and 51b, and it is easy for defects DF to spread inside GaN layers 51a and 51b.

With reference to FIG. 3(b), since the GaN growth temperature becomes high in this embodiment, GaN two-dimensional growth is promoted, and defects DF such as pits that were present in the layer under the GaN layer 51a or 51b are covered by the GaN layer 51a or 51b. As a result, the defect density of each of GaN layers 51a and 51b can be reduced, and it is possible to avoid a situation in which the defects DF penetrate the compound semiconductor substrate in the vertical direction and the withstand voltage of the compound semiconductor substrate is significantly reduced.

FIG. 4 is a plan view showing the configuration of compound semiconductor substrate CS1 in the first embodiment of the present invention.

With reference to FIG. 4, the planar shape of compound semiconductor substrate CS1 is optional. If the compound semiconductor substrate CS1 has a circular planar shape, the diameter of the compound semiconductor substrate CS1 is 6 inches or more. When viewed in a plane, the center of compound semiconductor substrate CS1 is center PT1, the position 71.2 millimeters away from this center PT1 (corresponding to the position 5 millimeters away from the outer peripheral edge of a substrate with a diameter of 6 inches) is edge PT2.

As a result of improved quality of C-GaN layers 51a and 51b, the in-plane uniformity of each film thickness of C-GaN layers 51a and 51b is improved, and the in-plane uniformity of each C concentration of C-GaN layers 51a and 51b is improved. The vertical intrinsic breakdown voltage value of compound semiconductor substrate CS1 is improved and the defect density of each of GaN layers 51a and 51b is reduced. As a result, the in-plane uniformity of current-voltage characteristics in the vertical direction can be improved.

In particular, when the carbon concentration at the center position in the depth direction (the vertical direction in FIG. 1) at center PT1 of the GaN layer is concentration $C_1$, and the carbon concentration at the center position in the depth direction at edge PT2 of the GaN layer is concentration $C_2$, concentration error $\Delta C$ represented by $\Delta C$ (%) = | $C_1$-$C_2$ | * 100 / $C_1$ is 0 or more and 50% or less, preferably 0 or more and 33% or less.

Further, when the film thickness of center PT1 in the GaN layer is film thickness $W_1$, and the film thickness of edge PT2 in the GaN layer is film thickness $W_2$, film thickness error $\Delta W$ represented by $\Delta W$ (%) = | $W_1$-$W_2$ | * 100 / $W_1$ is greater than 0 and less than or equal to 8%, preferably greater than 0 and less than or equal to 4%.

The vertical intrinsic breakdown voltage value of compound semiconductor substrate CS1 is 1200V or more and 1600V or less. The defect density of center PT1 of GaN layers 51a and 51b causing insulation breakdown at a voltage value of 80% or less of this intrinsic breakdown voltage value is greater than 0 and less than or equal to 100 pieces / cm², preferably greater than 0 and less than or equal to 2 pieces / cm². Also, the defect density of edge PT2 of GaN layers 51a and 51b causing insulation breakdown at a voltage value of 80% or less of this intrinsic breakdown voltage value is greater than 0 and less than or equal to 7 pieces / cm², preferably greater than 0 and less than or equal to 2 pieces / cm².

[Second embodiment]

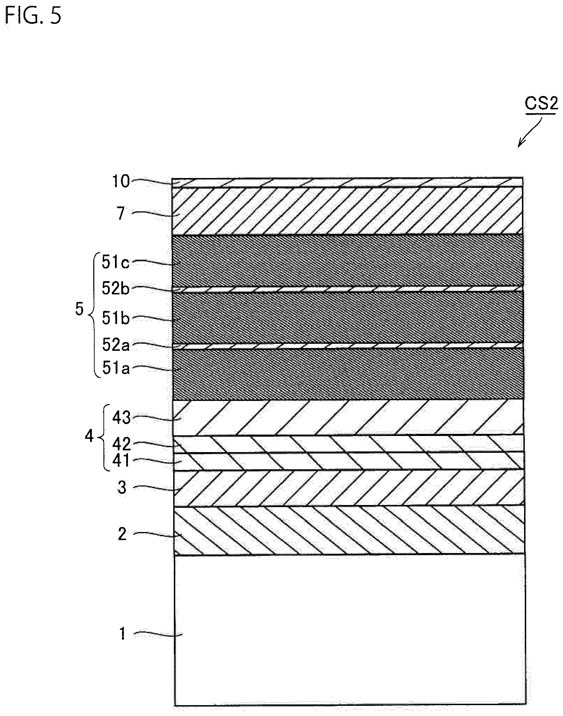

FIG. 5 is a cross-sectional view showing the configuration of compound semiconductor substrate CS2 in the second embodiment of the present invention.
With reference to FIG. 5, the compound semiconductor substrate CS2 in this embodiment is different in the internal configuration of the composite layer 5, from the compound semiconductor substrate CS1 in the first embodiment. In particular, composite layer 5 according to the present embodiment includes 3 layers of C-GaN layers 51a, 51b, 51c as C-GaN layers, and 2 layers of AlN layers 52a and 52b. C-GaN layer 51a is the lowest layer of the layers that make up composite layer 5, and in contact with Al nitride semiconductor layer 4. AlN layer 52a is formed on C-GaN layer 51a and in contact with C-GaN layer 51a. C-GaN layer 51b is formed on AlN layer 52a and in contact with AlN layer 52a. AlN layer 52b is formed on C-GaN layer 51b and in contact with C-GaN layer 51b. C-GaN layer 51c is formed on AlN layer 52b and in contact with AlN layer 52b. C-GaN layer 51c is the highest layer among the layers that make up composite layer 5, and in contact with GaN layer 7.
Since the configuration of compound semiconductor substrate CS2 other than the above is the same as the configuration of compound semiconductor substrate CS1 in the first embodiment, the same member is given the same numeral, and the description will not be repeated.
According to this embodiment, the same effect as the first embodiment can be obtained. In addition, since there are 2 layers of AlN layers 52a and 52b in composite layer 5, the effect of giving compressive strain to upper GaN layers 51b and 51c and GaN layer 7 is increased. As a result, the occurrence of warpage in Si substrate 1 can be suppressed, and the occurrence of cracks into C-GaN layers 51a, 51b and 51c, and GaN layer 7 can be suppressed.
Also, since there are 2 layers of AlN layers 52a and 52b in composite layer 5, the vertical withstand voltage of the compound semiconductor substrate can be improved.

[Modification]

In this modification, the configuration of modification in Al nitride semiconductor layer 4 of compound semiconductor substrates CS1 and CS2 respectively is described.

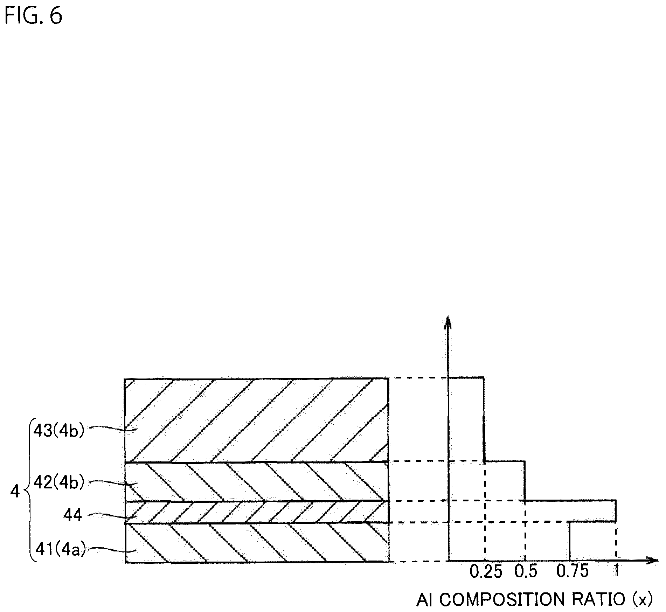

FIG. 6 is a diagram showing the distribution of the Al composition ratio inside Al nitride semiconductor layer 4 in the first modification of the present invention.
With reference to FIG. 6, Al nitride semiconductor layer 4 in this modification includes AlGaN layer 4a, AlN intermediate layer 44, and AlGaN layer 4b.
AlGaN layer 4a is formed on AlN buffer layer 3 and in contact with AlN buffer layer 3. AlGaN layer 4a consists of $Al_{0.75}Ga_{0.25}N$ layer 41 (an AlGaN layer with a composition ratio of Al is 0.75). The composition ratio of Al inside AlGaN layer 4a is constant.
AlN intermediate layer 44 is formed on AlGaN layer 4a. The bottom surface of AlN intermediate layer 44 is in contact with the top surface of AlGaN layer 4a, and the top surface of AlN intermediate layer 44 is in contact with the bottom surface of AlGaN layer 4b.
AlGaN layer 4b is formed on AlN intermediate layer 44. The composition ratio of Al inside AlGaN layer 4b decreases from the bottom to the top. AlGaN layer 4b is composed of $Al_{0.5}Ga_{0.5}N$ layer 42 (an AlGaN layer in which the composition ratio of Al is 0.5) and $Al_{0.25}Ga_{0.75}N$ layer 43 (an AlGaN layer in which the composition ratio of Al is 0.25) being in contact with $Al_{0.5}Ga_{0.5}N$ layer 42 and formed on $Al_{0.5}Ga_{0.5}N$ layer 42.

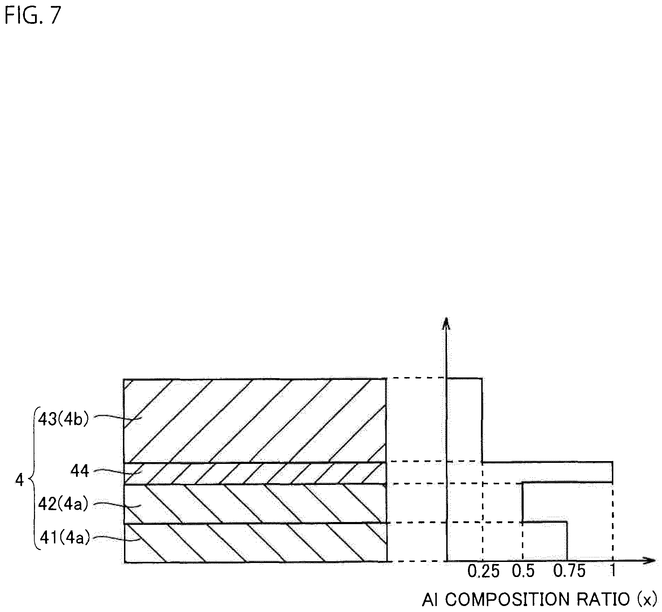

FIG. 7 is a diagram showing the distribution of the Al composition ratio inside Al nitride semiconductor layer 4 in the second modification of the present invention.
With reference to FIG. 7, Al nitride semiconductor layer 4 in this modification includes AlGaN layer 4a, AlN intermediate layer 44, and AlGaN layer 4b.
AlGaN layer 4a is formed on AlN buffer layer 3 and in contact with AlN buffer layer 3. The composition ratio of Al inside AlGaN layer 4a decreases from the bottom to the top. AlGaN layer 4a is composed of $Al_{0.75}Ga_{0.25}N$ layer 41 (an AlGaN layer with a composition ratio of Al is 0.75) and $Al_{0.5}Ga_{0.5}N$ layer 42 (an AlGaN layer in which the composition ratio of Al is 0.5) formed on $Al_{0.75}Ga_{0.25}N$ layer 41 and in contact with $Al_{0.75}Ga_{0.25}N$ layer 41.
AlN intermediate layer 44 is formed on AlGaN layer 4a. The bottom surface of AlN intermediate layer 44 is in contact with the top surface of AlGaN layer 4a, and the top surface of AlN intermediate layer 44 is in contact with the bottom surface of AlGaN layer 4b.
AlGaN layer 4b is formed on AlN intermediate layer 44. Al GaN layer 4b consists of $Al_{0.25}Ga_{0.75}N$ layer 43 (an AlGaN layer in which the composition ratio of Al is 0.25). The composition ratio of Al inside AlGaN layer 4b is constant.
Since the configurations other than the above in each of the compound semiconductor substrates of the first and second modifications are the same as the configurations in the case of the above-described embodiment, the description will not be repeated.

AlN intermediate layer 44 serves to generate compressive strain in AlGaN layer 4b, By providing AlN intermediate layer 44 as in the first and second modifications, warpage and cracks can be further suppressed.

[Examples]

As the first Example, the inventors of the present application have produced each of Samples 1 to 3 having the configuration described below as samples.

Sample 1: The compound semiconductor substrate CS1 shown in FIG. 1 was manufactured. The thickness of each of C-GaN layers 51a and 51b was set to about 2 micrometers, and the thickness of AlN layer 52a was set to 15 nanometers. Each average carbon concentration of C-GaN layers 51a and 51b was set to a value within the range of $3 * 10^{18}$ pieces / cm$^3$ or more and $1 * 10^{20}$ pieces / cm$^3$ or less.

Sample 2: The compound semiconductor substrate CS2 shown in FIG. 5 was manufactured. The thickness of each of C-GaN layers 51a, 51b, and 51c was set to about 1 micrometer, and the thickness of each of AlN layers 52a and 52b was set to 15 nanometers. Each average carbon concentration of C-GaN layers 51a, 51b, and 51c was set to a value within the range of $3 * 10^{18}$ pieces / cm$^3$ or more and $1 * 10^{20}$ pieces / cm$^3$ or less.

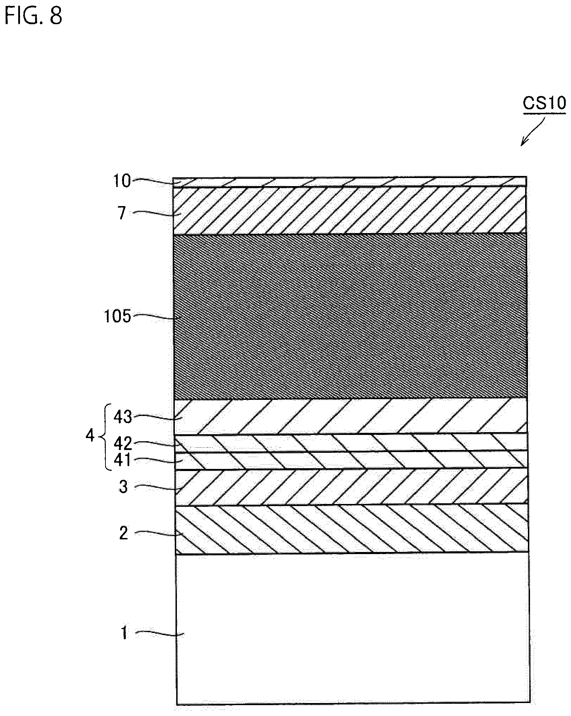

Sample 3: The compound semiconductor substrate CS10 shown in FIG. 8 was manufactured. Compound semiconductor substrate CS10 differs from compound semiconductor substrate CS1 (Sample 1) in that C-GaN layer 105 is formed instead of composite layer 5, and the other configurations are same as compound semiconductor substrate CS1 (Sample 1). The average carbon concentration of C-GaN layer 105 was set to a value within the range of $3 * 10^{18}$ pieces / cm$^3$ or more and $1 * 10^{20}$ pieces / cm$^3$ or less.

For each of the obtained Samples, the inventors of the present application visually confirmed the presence or absence of cracks, measured the warpage amount, and measured the vertical withstand voltage (withstand voltage in the thickness direction of the compound semiconductor substrate).

As vertical withstand voltages, the values when the vertical withstand voltage of Sample 3 is the reference (zero) were measured. Also, as the warpage amount, "convex" is when warpage occurs so that it becomes a convex shape when the Si substrate in compound semiconductor substrate is on the lower side, and "concave" is when warpage occurs so that it becomes a concave shape when the Si substrate in compound semiconductor substrate is on the lower side.

As a result, in Sample 3, cracks were observed in the area on the outer periphery side of edge PT2, whereas in Samples 1 and 2, cracks were not observed over the entire surface. In addition, no crack was observed in the region from center PT1 to edge PT2 in any of samples 1 to 3 (crack-free). In Sample 3, it was the large warpage amount with a concave shape of 146 micrometers, while in Sample 1, it was the small warpage amount with a concave shape of 43 micrometers. Furthermore, in Sample 2, it was the warpage amount of 27 micrometers of a convex shape. The convex warpage of Sample 2 is caused by the large compressive strain of the C-GaN layer in the compound semiconductor substrate, and it shows a great effect of suppressing the occurrence of cracks. From these results, it can be seen that Samples 1 and 2 suppress the occurrence of cracks and improve the warpage of the substrate, as compared with Sample 3.

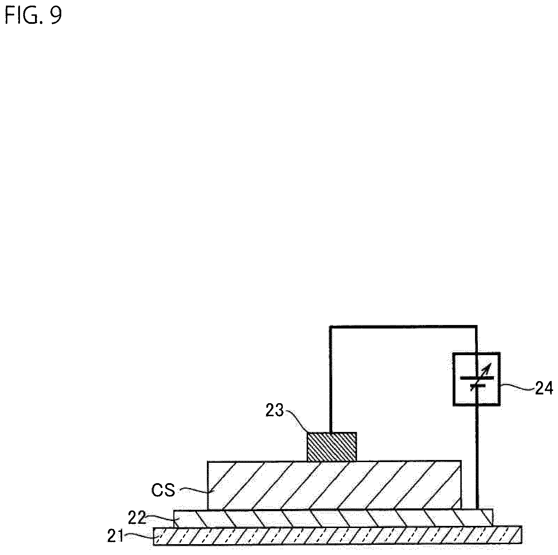

FIG. 9 is a cross-sectional view showing a method of measuring the vertical withstand voltage in the first Example of the present invention.

With reference to FIG. 9, the compound semiconductor substrate CS of the Sample to be measured was fixed on the copper plate 22 pasted on glass plate 21. On the Al nitride semiconductor layer 10 of fixed compound semiconductor substrate CS, electrode 23 made of Al was provided so as to contact the Al nitride semiconductor layer 10. A terminal of curve tracer 24 was connected to copper plate 22 and another terminal was connected to electrode 23. A voltage is applied between copper plate 22 and electrode 23 using curve tracer 24, and the density of current flowing between copper plate 22 and electrode 23 (current flowing vertically through the sample) was measured. When the measured current density reaches $1 * 10^{-1}$ A / mm$^2$, it is considered that the sample has undergone insulation breakdown, and the voltage between copper plate 22 and electrode 23 at this time was measured as the withstand voltage.

As a result of the measurement, vertical withstand voltage of Sample 1 was higher than Sample 3 by 60V. The vertical withstand voltage of Sample 2 was 85V higher than Sample 3. From these results, it can be seen that Samples I and 2 have improved vertical withstand voltage as compared to Sample 3.

As the second Example, the inventors of the present application produced compound semiconductor substrate CS3 having a diameter of 6 inches under two manufacturing conditions, and obtained each of Example A of the present invention and Comparative example B.

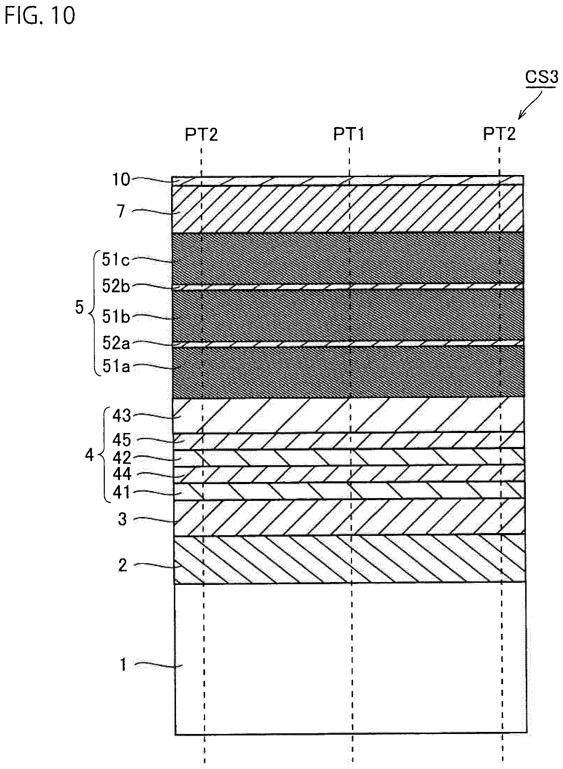

FIG. 10 is a cross-sectional view showing the configuration of compound semiconductor substrate CS3 in the second Example of the present invention.

With reference to FIG. 10, the configuration of compound semiconductor substrate CS3 is the same as the configuration of compound semiconductor substrate CS2 shown in FIG. 5, except for Al nitride semiconductor layer 4. Al nitride semiconductor layer 4 of compound semiconductor substrate CS3 includes $Al_{0.75}Ga_{0.25}N$ layer 41, $Al_{0.5}Ga_{0.5}N$ layer 42, $Al_{0.25}Ga_{0.75}N$ layer 43, and AlN intermediate layers 44 and 45. $Al_{0.75}Ga_{0.25}N$ layer 41 is the bottom layer of Al nitride semiconductor layer 4 and is formed on AlN buffer layer 3 and in contact with AlN buffer layer 3, AlN intermediate layer 44 is formed on $Al_{0.75}Ga_{0.25}N$ layer 41 and in contact with $Al_{0.75}Ga_{0.25}N$ layer 41. $Al_{0.5}Ga_{0.5}N$ layer 42 is formed on AlN intermediate layer 44 and in contact with AlN intermediate layer 44. AlN intermediate layer 45 is formed on $Al_{0.5}Ga_{0.5}N$ layer 42 and in contact with $Al_{0.5}Ga_{0.5}N$ layer 42. $Al_{0.25}Ga_{0.75}N$ layer 43 is the highest layer of Al nitride semiconductor layer 4 and is formed on AlN intermediate layer 45 and in contact with AlN intermediate layer 45.

In compound semiconductor substrate CS3, the thickness of Si substrate 1 was set to 1000 micrometers and the thickness of SiC layer 2 was set to 1 micrometer, the sum total thickness of AlN buffer layer 3 and Al nitride semiconductor layer 4 was set to 1 micrometer, and the thickness of each of AlN intermediate layers 52a and 52b was set to 15 nanometers, the thickness of GaN layer 7 was set to 0,5 micrometers, and the thickness of Al nitride semiconductor layer 10 was set to 25 nanometers. The thickness of each of C-GaN layers 51a, 51b, and 51c was set to about 2 micrometers.

Example of the present invention A: When forming each of C-GaN layers 51a, 51b, and 51c, the film forming temperature was set to a high temperature (about 200 degrees Celsius lower temperature than the growth temperature of the GaN layer which was not doped with C) and hydrocarbon was introduced as C source gas.

Comparative example B: When forming each of C-GaN layers 51a, 51b, and 51c, the film forming temperature was set to a low temperature (about 300 degrees Celsius lower temperature than the growth temperature of the GaN layer which was not doped with C) and no C source gas was introduced.

Subsequently, the inventors of the present application visually confirmed the presence or absence of cracks occurred into compound semiconductor substrate CS3. As a result, no crack occurred in either example of the present invention A and Comparative example B.

Subsequently, the inventors of the present application confirmed the presence or absence of melt back etching (a phenomenon that the crystal is altered by the reaction between Si and Ga) into Si substrate 1 of compound semiconductor substrate CS3 by observation with an optical microscope. As a result, melt back etching did not occur in either the example of the present invention A and Comparative example B (Both the example of the present invention A and Comparative example B satisfied meltback-free on the entire substrate).

Next, the inventors of the present application measured the carbon concentration distribution in the depth direction at center PT1 and the carbon concentration distribution in the depth direction at edge PT2 for each of C-GaN layers 51a, 51b, and 51c of compound semiconductor substrate CS3. SIMS (Secondary Ion Mass Spectrometry) was used for this measurement. Next, based on the measured carbon concentration distribution, concentration C1 which is the carbon concentration at the center position in the depth direction at center PT1, and concentration C2 which is the carbon concentration at the center position in the depth direction at edge PT2 were calculated. Next, concentration error $\Delta C$ represented by $\Delta C\ (\%) = |\ C1\text{-}C2\ |\ *\ 100\ /\ C1$ was calculated based on the calculated concentrations C1 and C2.

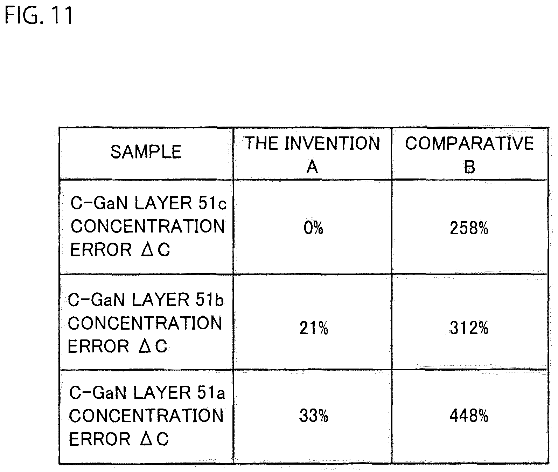

FIG. 11 is a diagram showing the values of concentration errors $\Delta C$ calculated in the second Example of the present invention.

With reference to FIG. 11, in the example of the present invention A, the range of the carbon concentration in the depth direction at each center PT1 of C-GaN layers 51a, 51b, and 51c is $4 * 10^{18}$ pieces / $cm^2$ or more and $8 * 10^{18}$ pieces / $cm^2$ or less, and the range of the carbon concentration in the depth direction at edge PT2 is $4.3 * 10^{18}$ pieces / $cm^2$ or more and $7 * 10^{18}$ or less. According to the example of the present invention A, the carbon concentration of center PT1 and the carbon concentration of edge PT2 are almost the same value, and the concentration errors $\Delta C$ of C-GaN layers 51a, 51b, and 51c were 33%, 21%, and 0%, respectively. The inventors of the present application produced a plurality of example of the present invention A, and measured each concentration error $\Delta C$ of the obtained plurality of example of the present invention A by the above-mentioned method. As a result, according to all the example of the present invention A, concentration errors $\Delta C$ were values within the range of 0 or more and 50% or less.

On the other hand, according to Comparative example B, the range of the carbon concentration in the depth direction at each center PT1 of C-GaN layers 51a, 51b, and 51c was $5 * 10^{18}$ pieces / $cm^2$ or more and $1.5 * 10^{19}$ pieces / $cm^2$ or less, and the range of the carbon concentration in the depth direction at edge PT2 was $2.3 * 10^{19}$ pieces / $cm^2$ or more and $4.2 * 10^{19}$ pieces / $cm^2$ or less. In Comparative example B, the carbon concentration of edge PT2 is higher than the carbon concentration of center PT1, and the concentration errors $\Delta C$ of C-GaN layers 51a, 51b, and 51c were 448%, 312%, and 258%, respectively.

From the above results, it can be seen that the in-plane uniformity of the carbon concentration of the C-GaN layer is improved in the example of the present invention A, as compared with Comparative example B.

Next, the inventors of the present application measured each of film thickness W1, which is the film thickness of center PT1, and film thickness W2, which is the film thickness of edge PT2, for each of C-GaN layers 51a, 51b, and 51c of compound semiconductor substrate CS3. This measurement was performed by observing the cross section of compound semiconductor substrate CS3 using a TEM (Transmission Electron Microscope). Next, film thickness error $\Delta W$ represented by $\Delta W\ (\%) = |\ W1\text{-}W2\ |\ *\ 100\ /\ W1$ was calculated based on the measured film thicknesses W1 and W2.

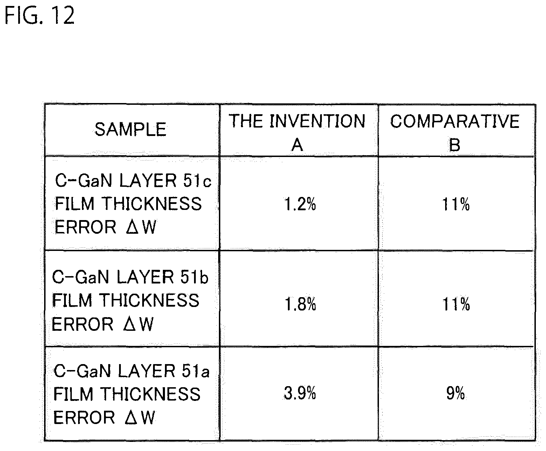

FIG. 12 is a diagram showing the value of film thickness error $\Delta W$ calculated in the second Example of the present invention.

With reference to FIG. 12, according to the example of the present invention A, the film thickness errors $\Delta W$ of C-GaN layers 51a, 51b, and 51c were 3.9%, 1.8%, and 1.2%, respectively, which are small values. The inventors of the present application produced a plurality of example of the present invention A as example of the present invention A, and measured each film thickness error ∆W of the obtained the plurality of example of the present invention A by the above-mentioned method. As a result, according to all the example of the present invention A, film thickness errors ∆W were in a range greater than 0 and 8% or less.

On the other hand, according to Comparative example B, the film thickness errors ∆W of C-GaN layers 51a, 51b, and 51c were 9%, 11%, and 11%, respectively, which are large values.

From the above results, it can be seen that in-plane uniformity of the film thickness of the C-GaN layer is improved in example of the present invention A, as compared with Comparative example B.

Next, the inventors of the present application measured the intrinsic breakdown voltage of compound semiconductor substrate CS3. The measurement of the intrinsic breakdown voltage was basically performed by the same method as shown in FIG 9. As electrode 23, an electrode (specifically, an electrode with a diameter of 0.1 cm) having a sufficiently small area is used, electrode 23 was contacted to four different positions of the surface of Al nitride semiconductor layer 10 in turn, in compound semiconductor substrate CS3, and the density of the current flowing between copper plate 22 and electrode 23 (current flowing in the vertical direction of the sample) when electrode 23 was brought into contact with each position was measured. When the measured current density reaches $1 * 10^{-1} A / mm^2$, it is considered that the sample has undergone insulation breakdown, and the voltage between copper plate 22 and electrode 23 at this time was measured. Exclude the highest and lowest values of the four voltages obtained, and the average value of the remaining two values was defined as the intrinsic breakdown voltage. Multiple samples were prepared as example of the present invention A, and the intrinsic breakdown voltage for each sample was measured. As a result, all the intrinsic breakdown voltages of the example of the present invention A were values of 1200V or more and 1600V or less.

Furthermore, the inventors of the present application measured the defect density of the GaN layer (any GaN layer out of GaN layers 51a, 51b, and 51c) of compound semiconductor substrate CS3 by the following method. First, electrode 23 is contacted to 5 different positions near center PT1 of the surface of Al nitride semiconductor layer 10 in turn, in compound semiconductor substrate CS3. The density of the current flowing between copper plate 22 and electrode 23 (current flowing in the vertical direction of the sample) when electrode 23 was brought into contact with each position was measured. When the measured current density reaches $1 * 10^{-1} A / mm^2$, it is considered that the sample has undergone insulation breakdown, and the voltage between copper plate 22 and electrode 23 at this time was regarded as the insulation breakdown voltage of center PT1, Next, the position where the measured insulation breakdown voltage is 80% or less of the intrinsic insulation breakdown voltage was judged as the position where defect exists. The ratio of the number of positions where defect exists to the five positions where insulation breakdown voltages were measured was calculated as the defect density D of center PT1.

The above-mentioned defect density D of center PT1 was calculated using each of electrodes having four different areas S (0.283 cm², 0.126 cm², 0.031 cm², 0.002 cm²). As a result, four pairs of electrode area S and defect density D of center PT1 were obtained.

Next, using Equation (1), which is a general Poisson equation showing the relationship among yield Y, area S of the electrode, and defect density D, yield Y was calculated for each of the four different areas S.

$$Y = \exp(-S*D) \ldots (1)$$

Next, the electrode with the area S where the calculated yield Y is closest to 50% is judged to be the most suitable electrode for the calculation of the defect density. Defect density D corresponding to the area S of the suitable electrode was adopted as the defect density of center PT1,

Also, the contact position of electrode 23 is changed to 5 different positions near edge PT2 of the surface of Al nitride semiconductor layer 10, the defect density of edge PT2 was measured by the same method as above.

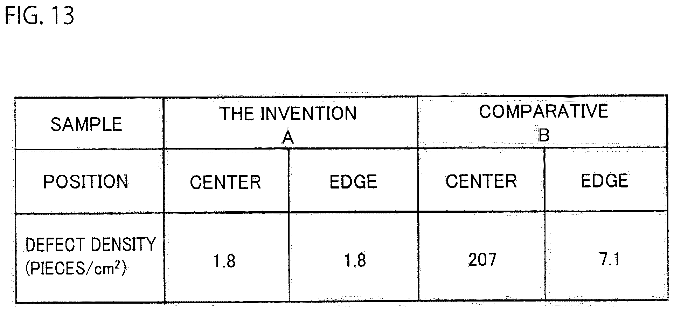

FIG. 13 is a diagram showing the value of the defect density measured in the second Example of the present invention.

With reference to FIG. 13, the defect density of center PT1 of the example of the present invention A was 1.8 pieces / cm², and the defect density of edge PT2 of the example of the present invention A was 1.8 pieces / cm². The inventors of the present application produced a plurality of example of the present invention A, and the defect densities of center PT1 and edge PT2 of each of the obtained a plurality of example of the present invention A was measured by the method described above. As a result, according to all the example of the present invention A, the defect densities were values within a range of larger than 0 and 7 pieces / cm² or less. On the other hand, the defect density of center PT1 of Comparative example B was 207 pieces / cm², and the defect density of edge PT2 of Comparative example B was 7.1 pieces / cm².

From the above results, it can be seen that the defect density of the GaN layer is reduced in the example of the present invention A, as compared with Comparative example B.

[Others]

The above embodiments and modifications can be combined as appropriate.

The embodiments, modifications and Examples described above should be considered in all respects as exemplary and not restrictive. The scope of the present invention is shown not by the above description but by the scope of the claims, and is intended to include meanings equivalent to the scope of the claims and all modifications within the scope.

[Explanation of symbols]

1 Si (silicon) substrate
2 SiC (the silicon carbide) layer
3 AlN (aluminum nitride) buffer layer (an example of a buffer layer containing AlN)
4, 10 Al (aluminum) nitride semiconductor layer (an example of a nitride semiconductor layer containing Al)
4a, 4b AlGaN (aluminum nitride gallium) layer
5 composite layer
7 GaN (gallium nitride) layer
21 glass plate
22 copper plate
23 electrode
24 curve tracer
41 $Al_{0.75}Ga_{0.25}N$ layer
42 $Al_{0.5}Ga_{0.5}N$ layer
43 $Al_{0.25}Ga_{0.75}N$ layer
44, 45 AlN intermediate layer
51a, 51b, 51c, 105 C(carbon)-GaN layer (an example of a GaN layer)
52a, 52b AlN layer (an example of an AlN layer)
CS, CS1, CS2, CS10 compound semiconductor substrate
PT1 center
PT2 edge

**Claims**

1. A compound semiconductor substrate with a center and an edge which is 71.2 millimeters away from the center when viewed in a plane comprising:

   a Si substrate,
   a buffer layer containing AlN formed on a top surface side of the Si substrate,
   a nitride semiconductor layer containing Al formed on a top surface side of the buffer layer, and
   a GaN layer formed on a top surface side of the nitride semiconductor layer, wherein
   when a film thickness of the GaN layer at the center is film thickness W1 and a film thickness of the GaN layer at the edge is film thickness W2, film thickness error $\Delta W$ represented by $\Delta W$ (%) = | W1-W2 | $*$ 100 / W1 is greater than 0 and 8% or less,
   an average carbon concentration of a depth direction at the center of the GaN layer is 3 $*$ $10^{18}$ pieces / $cm^3$ or more and 5 $*$ $10^{20}$ pieces / $cm^3$ or less, and
   when a carbon concentration at a center position of a depth direction at the center of the GaN layer is concentration C1, and a carbon concentration at a center position of the depth direction in the edge of the GaN layer is concentration C2, concentration error $\Delta C$ represented by $\Delta C$ (%) = | C1-C2 | $*$ 100 / C1 is 0 or more and 50% or less.

2. The compound semiconductor substrate according to the claim 1, further comprising a SiC layer formed on a top surface of the Si substrate.

3. The compound semiconductor substrate according to the claim 2, further comprising a composite layer formed on the top surface side of the nitride semiconductor layer, wherein the composite layer includes

   the GaN layer, and
   an AlN layer formed on a top surface of the GaN layer.

4. The compound semiconductor substrate according to the claim 3, wherein
   a vertical intrinsic breakdown voltage value of the compound semiconductor substrate is 1200V or more and 1600V or less.

5. The compound semiconductor substrate according to the claim 4, wherein
   a defect density of the center of the GaN layer causing insulation breakdown at a voltage value 80% or less of the intrinsic breakdown voltage value is greater than 0 and less than or equal to 100 pieces / $cm^2$.

6. The compound semiconductor substrate according to the claim 4, wherein
   a defect density of the edge of the GaN layer causing insulation breakdown at a voltage value 80% or less of the intrinsic breakdown voltage value is greater than 0 and less than or equal to 7 pieces / $cm^2$.

7. The compound semiconductor substrate according to the claim 2, wherein
   an area from the center to the edge is crack-free.

8. The compound semiconductor substrate according to the claim 2, wherein meltback-free is satisfied on an entire surface of the substrate.

FIG. 1

FIG. 2

4 { 43
42
41

0.25  0.5  0.75

Al COMPOSITION RATIO (x)

FIG. 3

(a)

51a,51b

DF    DF

(b)

51a,51b

DF    DF

FIG. 4

FIG. 5

FIG. 6

AI COMPOSITION RATIO (x)

FIG. 7

Al COMPOSITION RATIO (x)

FIG. 8

FIG. 9

FIG. 10

FIG. 11

| SAMPLE | THE INVENTION A | COMPARATIVE B |
|---|---|---|
| C-GaN LAYER 51c CONCENTRATION ERROR $\Delta C$ | 0% | 258% |
| C-GaN LAYER 51b CONCENTRATION ERROR $\Delta C$ | 21% | 312% |
| C-GaN LAYER 51a CONCENTRATION ERROR $\Delta C$ | 33% | 448% |

FIG. 12

| SAMPLE | THE INVENTION A | COMPARATIVE B |
|---|---|---|
| C-GaN LAYER 51c FILM THICKNESS ERROR ΔW | 1.2% | 11% |
| C-GaN LAYER 51b FILM THICKNESS ERROR ΔW | 1.8% | 11% |
| C-GaN LAYER 51a FILM THICKNESS ERROR ΔW | 3.9% | 9% |

FIG. 13

| SAMPLE | THE INVENTION A | | COMPARATIVE B | |
|---|---|---|---|---|
| POSITION | CENTER | EDGE | CENTER | EDGE |
| DEFECT DENSITY (PIECES/cm²) | 1.8 | 1.8 | 207 | 7.1 |

**INTERNATIONAL SEARCH REPORT**

| International application No. |
| --- |
| PCT/JP2020/000246 |

| A. CLASSIFICATION OF SUBJECT MATTER |
| --- |
| Int.Cl. C30B25/02(2006.01)i, H01L21/20(2006.01)i, H01L21/205(2006.01)i, H01L21/338(2006.01)i, H01L29/778(2006.01)i, H01L29/812(2006.01)i, C30B29/38(2006.01)i, C23C16/34(2006.01)i<br>FI: H01L21/20, H01L29/80H, H01L21/205, C23C16/34, C30B29/38C, C30B29/38D, C30B25/02Z |
| According to International Patent Classification (IPC) or to both national classification and IPC |

| B. FIELDS SEARCHED |
| --- |
| Minimum documentation searched (classification system followed by classification symbols)<br>Int.Cl. C30B25/02, H01L21/20, H01L21/205, H01L21/338, H01L29/778, H01L29/812, C30B29/38, C23C16/34 |

| Documentation searched other than minimum documentation to the extent that such documents are included in the fields searched |
| --- |
| Published examined utility model applications of Japan    1922–1996<br>Published unexamined utility model applications of Japan    1971–2020<br>Registered utility model specifications of Japan    1996–2020<br>Published registered utility model applications of Japan    1994–2020 |

| Electronic data base consulted during the international search (name of data base and, where practicable, search terms used) |
| --- |
|  |

**C. DOCUMENTS CONSIDERED TO BE RELEVANT**

| Category* | Citation of document, with indication, where appropriate, of the relevant passages | Relevant to claim No. |
| --- | --- | --- |
| Y | JP 2018-174234 A (AIR WATER INC.) 08.11.2018 (2018-11-08), paragraphs [0022]-[0049], fig. 1, 2 | 1-8 |
| Y | WO 2017/100141 A1 (IQE, PLC) 15.06.2017 (2017-06-15), paragraphs [0012], [0023] | 1-8 |
| Y | JP 2011-216579 A (ADVANCED POWER DEVICE RESEARCH ASSOCIATION) 27.10.2011 (2011-10-27), paragraphs [0006], [0007], [0020]-[0022], [0041], [0042] | 1-8 |
| Y | JP 2010-239034 A (FURUKAWA ELECTRIC CO., LTD.) 21.10.2010 (2010-10-21), paragraphs [0036], [0037] | 1-8 |

☐ Further documents are listed in the continuation of Box C.    ☒ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    13.03.2020 | Date of mailing of the international search report<br>    24.03.2020 |
| --- | --- |
| Name and mailing address of the ISA/<br>    Japan Patent Office<br>    3-4-3, Kasumigaseki, Chiyoda-ku,<br>    Tokyo 100-8915, Japan | Authorized officer<br><br>Telephone No. |

Form PCT/ISA/210 (second sheet) (January 2015)

| INTERNATIONAL SEARCH REPORT | International application No. |
|---|---|
| Information on patent family members | PCT/JP2020/000246 |

| JP 2018-174234 A | 08.11.2018 | WO 2018/180312 A1 TW 201843711 A CN 110402484 A |
|---|---|---|
| WO 2017/100141 A1 | 15.06.2017 | JP 2019-505459 A US 2017/0170283 A1 KR 10-2018-0100562 A TW 201732871 A |
| JP 2011-216579 A | 27.10.2011 | (Family: none) |
| JP 2010-239034 A | 21.10.2010 | US 2010/0244101 A1 paragraphs [0038], [0039] |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013179121 A
- JP 2015201574 W